# EUROPÄISCHE PATENTSCHRIFT

(11) **EP 3 639 365 B1**
(45) Veröffentlichungstag und Bekanntmachung des Hinweises auf die Patenterteilung: **19.08.2020**
(21) Anmeldenummer: 18713874.8
(22) Anmeldetag: 23.03.2018
(51) Int. Cl.: H02S 50/00

(54) **EINFEHLERSICHERE ISOLATIONSWIDERSTANDSBESTIMMUNG IN EINER PHOTOVOLTAIKANLAGE**
SINGLE-FAULT-TOLERANT ISOLATION RESISTANCE DETERMINATION IN A PHOTOVOLTAIC SYSTEM
DÉTERMINATION DE RÉSISTANCE D'ISOLATION À SÉCURITÉ INTÉGRÉE DANS UNE INSTALLATION PHOTOVOLTAÏQUE

(30) Priorität: 14.06.2017 DE 102017113192
(43) Veröffentlichungstag der Anmeldung: 22.04.2020
(73) Patentinhaber: SMA Solar Technology AG, 34266 Niestetal (DE)
(72) Erfinder: PUTZ, Martin, 34119 Kassel (DE)
(86) Internationale Anmeldenummer: PCT/EP2018/057513
(87) Internationale Veröffentlichungsnummer: WO 2018/228730

(56) Entgegenhaltungen:
- DE-A1-102014 206 454
- DE-B3-102006 037 043

## Beschreibung

Die Erfindung betrifft ein Verfahren zur einfehlersicheren Bestimmung eines Isolationswiderstands einer Photovoltaikanlage, sowie einen Wechselrichter, der zur Durchführung des Verfahrens eingerichtet ist.

Vor der Inbetriebnahme einer Photovoltaikanlage ist es aus Sicherheitsgründen erforderlich, festzustellen, ob der angeschlossene Solargenerator einen hinreichend hohen Widerstand gegenüber dem Erdpotential als Bezugspotential aufweist. In der Regel wird diese Prüfung zumindest durchgeführt, bevor die Photovoltaikanlage durch Verbindung des Wechselrichters mit einem angeschlossenen Netz in Betrieb genommen wird.

In den Druckschriften EP 1 857 825 A1, DE 10 2014 206454A1 und EP 2 230 522 A1 sind jeweils Verfahren beschrieben, in denen zur Bestimmung des Isolationswiderstands ein Strompfad zu einem Erdanschluss wechselweise mit je einem Pol einer Gleichstromquelle hergestellt wird und der sich jeweils ergebende Stromfluss miteinander verglichen wird.

Weiterhin ist in der Druckschrift DE 10 2012 104 752 B3 beschrieben, dass der wechselweise Strompfad durch die Brückenschalter einer Wechselrichter-Halbbrücke bereitgestellt, und dass so der zu vergleichende Stromfluss durch eine Wechselspannung mit einer bevorzugt unterhalb der Netzfrequenz liegenden Frequenz getrieben werden kann. Der Strompfad wird hierbei durch Schließen eines Erdschalters während der Isolationswiderstandsbestimmung hergestellt.

Bei diesen Verfahren wird im Falle eines Versagens des Erdschalters, insbesondere wenn der Erdschalter nicht korrekt schließt, ein Messergebnis erreicht, das einen hohen, gegebenenfalls nicht bestimmbar hohen Isolationswiderstand vortäuscht und damit einen sicheren Isolationszustand unabhängig von dem real vorliegenden Isolationszustand suggeriert. Um diesen Fall abzusichern, kann der Erdanschluss über einen geeignet dimensionierten Vergleichswiderstand mit einem Pol der Gleichstromquelle verbunden werden, so dass bei Bestimmung eines Isolationswiderstandes, der höher als der Widerstandswert des Vergleichswiderstandes auf einen fehlerhaften Erdschalter geschlossen werden kann. Nachteilig bei diesem Vorgehen ist allerdings, dass so die intrinsische Isolationseigenschaft des Wechselrichters dauerhaft verschlechtert wird. Alternativ wird in der Druckschrift DE 10 2015 102 468 B3 für eine Netzersatzanlage, bei der ein Neutralleiter mit einem Erdungsleiter im Netzersatzbetrieb zu verbinden ist, vorgeschlagen, zur Prüfung dieser Verbindung einen mit Spannung beaufschlagten Leiter über ein stromreduzierendes Element mit dem Erdungsleiter zu verbinden, um so einen Messstrom über die zu prüfende Verbindung zu erzeugen. Die vorstehend beschriebenen Nachteile durch den Prüfstrom bestehen hier ebenfalls.

Aufgabe der vorliegenden Erfindung ist es daher, ein Verfahren zur Bestimmung eines Isolationswiderstand einer Photovoltaikanlage aufzuzeigen, bei dem ein fehlerhafter Erdschalter erkannt werden kann, ohne dass die Isolationseigenschaften eines Wechselrichters der Photovoltaikanlage beeinträchtigt werden.

Diese Aufgabe wird gelöst durch ein Verfahren gemäß des unabhängigen Anspruchs 1. Vorteilhafte Ausgestaltungen des erfindungsgemäßen Verfahrens sind in den abhängigen Ansprüchen beschrieben. Das Verfahren kann in einem Wechselrichter eingesetzt werden.

Ein erfindungsgemäßes Verfahren zur einfehlersicheren Bestimmung eines Isolationswiderstands kann innerhalb einer Photovoltaikanlage ausgeführt werden, die einen Wechselrichter und einen daran angeschlossenen Solargenerator umfasst, wobei der Isolationswiderstand in Abhängigkeit einer in einem Widerstandsnetzwerk abfallenden Prüfspannung bestimmt wird, wobei das Widerstandsnetzwerk über einen ersten Anschluss mit einer variablen Spannungsquelle, über einen zweiten Anschluss mit einem ersten Pol des Solargenerators und mit einem dritten Anschluss über ein Isolationsrelais mit einem Erdanschluss des Wechselrichters verbunden ist. Ein Kondensator ist zwischen dem Erdanschluss und dem ersten Pol des Solargenerators angeordnet. Das erfindungsgemäße Verfahren umfasst die folgenden Schritte in beliebiger Reihenfolge:
- Anlegen eines ersten Gleichspannungswerts durch die variable Spannungsquelle an dem ersten Anschluss bei geschlossenem Isolationsrelais (Schritt A)
- Anlegen eines zweiten Gleichspannungswerts durch die variable Spannungsquelle an dem ersten Anschluss bei geschlossenem Isolationsrelais (Schritt B)
- Erzeugen einer Wechselspannung am ersten Anschluss mithilfe der variablen Spannungsquelle bei geöffnetem Isolationsrelais (Schritt C), sowie
- Erzeugen der Wechselspannung am ersten Anschluss mithilfe der variable Spannungsquelle bei geschlossenem Isolationsrelais (Schritt D).

Eine Funktionsprüfung des Isolationsrelais wird durch Vergleich einer Amplitude der Prüfspannung zwischen den beide Schritten durchgeführt, in denen die Wechselspannung erzeugt wird. Die Amplitude der Prüfspannung ändert sich durch das Schalten des Isolationsrelais, da der Kondensator eine definierte Impedanz bildet über den ein Wechselstrom bei geschlossenem Isolationsrelais fließen kann. Die DC-Isolationseigenschaften des Wechselrichters werden durch diesen Kondensator, der auch das EMV-Verhalten des Wechselrichters verbessert, aber nicht nachteilig verändert.

Der Isolationswiderstand kann vorteilhaft in Abhängigkeit der Differenz der Prüfspannung zwischen den Schritten bestimmt werden, in denen der erste beziehungsweise zweite Gleichspannungswert an dem ersten Anschluss angelegt ist.

Bei der Durchführung des erfindungsgemäßen Verfahrens ist der Wechselrichter bevorzugt vom Netz getrennt. Der Isolationswiderstand wird beispielsweise morgens vor der Zuschaltung zum Netz bestimmt. Die Zuschaltung wird nur im Fall eines zulässig hohen Isolationswiderstands und bei funktionstüchtigem Isolationsrelais durchgeführt.

Besonders vorteilhaft ist es, wenn die variable Spannungsquelle durch eine zwischen dem ersten Pol und einem zweiten Pol angeordneten Wechselrichterbrücke des Wechselrichters gebildet wird, deren Mittelpunkt mit dem ersten Anschluss des Widerstandsnetzwerks, bevorzugt über einen Netzfilter, verbunden ist. Hier können der erste und zweite Gleichspannungswert einfach dadurch angelegt werden, dass der erste Anschluss durch dauerhaftes Schließen jeweils eines der Schalter der Wechselrichterbrücke mit dem ersten beziehungsweise zweiten Pol verbunden wird,

In einer bevorzugten Ausführungsvariante des erfindungsgemäßen Verfahrens wird die Wechselspannung am ersten Anschluss mit Netzfrequenz erzeugt. Es ist aber auch denkbar, dass eine andere Frequenz, insbesondere ein höhere Frequenz als die Netzfrequenz verwendet wird. Hierdurch wird der Einfluss auf die Dämpfung der Spannungsamplitude durch den Kondensator bei geschlossenem Isolationsrelais im Vergleich zur Spannungsamplitude bei geöffnetem Isolationsrelais verstärkt.

Bevorzugt ist der erste Anschluss über einen Netzfilter mit dem Mittelpunkt der Wechselrichterbrücke verbunden. Hierdurch werden bei der Erzeugung der Wechselspannung mittels der Halbbrücke erzeugte hochfrequente Wechselspannungssignale effektiv aus der bestimmten Prüfspannung eliminiert.

Um die Anzahl der Schaltvorgänge des Isolationsrelais zu minimieren, ist es vorteilhaft, die Schritte, die bei geschlossenem Isolationsrelais durchgeführt werden, nacheinander durchzuführen. Weiterhin vorteilhaft ist es, beide Schritte, in denen eine Wechselspannung durch die Halbbrücke erzeugt wird, nacheinander durchzuführen. Eine besonders geeignete Reihenfolge zur Durchführung der Schritte ist es, zunächst in Schritt C, dann den Schritt D, dann den Schritt A und anschließend den Schritt B durchzuführen. Ebenfalls denkbar ist es aber auch, zunächst die Schritte A und B durchzuführen, dann den Schritt D und am Ende den Schritt C. Andere Reihenfolgen sollen hierdurch aber nicht ausgeschlossen werden.

In einer Variante wird das Verfahren erneut durchgeführt, wenn die Funktionsprüfung des Isolationsrelais oder die Bestimmung des Isolationswiderstands zu unzulässigen Ergebnissen geführt hat. Dies ist beispielsweise der Fall, wenn die im Schritt D bestimmte Amplitude größer ist als die im Schritt C bestimmte Amplitude. Anstelle des gesamten Verfahrens können aber auch nur einzelne Verfahrensschritte, beispielsweise die Schritte C und D, wiederholt werden. Auch im Falle eines bestimmten Isolationswiderstands, der keinen ordnungsgemäßen Betrieb der Photovoltaikanlage zulässt, kann das Verfahren (oder nur die Schritte A und B) erneut ausgeführt werden, um das Ergebnis zu verifizieren. Ein erstes Fehlersignal kann im Falle einer negativen Funktionsprüfung des Isolationsrelais erzeugt werden, ein zweites Fehlersignal im Fall eines als für einen zulässigen Betrieb der Photovoltaikanlage zu niedrig bestimmten Isolationswiderstands. Das erste und/oder zweite Fehlersignal kann innerhalb der Photovoltaikanlage oder zu einem Empfänger außerhalb der Photovoltaikanlage übertragen werden.

Die Prüfspannung kann in einer Ausführung als eine über einen mit dem ersten Pol des Solargenerators verbundenen Widerstand abfallende Spannung bestimmt werden. Dies ist insbesondere dann vorteilhaft, wenn Teile der Messelektronik des Wechselrichters das Potenzial des ersten Pols als Referenzpotenzial verwenden. Weiterhin kann das Widerstandsnetzwerk einen Begrenzungswiderstand aufweisen, der zwischen dem ersten Anschluss und dem dritten Anschluss angeordnet ist und insbesondere den im Fall eines extrem niedrigen Isolationswiderstands bei geschlossenem Isolationsrelais fließenden Strom begrenzt.

Ein erfindungsgemäßer Wechselrichter ist zur Durchführung des Verfahrens eingerichtet und steuert die Verfahrensschritte mit seiner Steuerelektronik. Der erfindungsgemäße Wechselrichter umfasst hierbei ein Widerstandsnetzwerk zur Bestimmung eines Isolationswiderstandes, wobei das Widerstandsnetzwerk über einen ersten Anschluss mit einer variablen Spannungsquelle des Wechselrichters, über einen zweiten Anschluss mit einem ersten Pol des Wechselrichters zum Anschluss eines Solargenerators und mit einem dritten Anschluss über ein Isolationsrelais des Wechselrichters mit einem Erdanschluss des Wechselrichters verbunden ist. Ein Kondensator ist zwischen dem Erdanschluss und dem ersten Pol angeordnet.

Im Folgenden wird die Erfindung mithilfe von Figuren näher ausgeführt, von denen
Fig. 1 einen Wechselrichter zur Ausführung des erfindungsgemäßen Verfahrens,
Fig. 2 eine bevorzugte Ausbildung eines Wechselrichters zur Ausführung des erfindungsgemäßen Verfahrens,
Fig. 3 ein Flussdiagramm des erfindungsgemäßen Verfahrens,
Fig. 4a einen beispielhaften Zeitverlauf einer Prüfspannung bei defektem Isolationsrelais, sowie
Fig. 4b einen beispielhaften Zeitverlauf einer Prüfspannung bei intaktem Isolationsrelais zeigen.

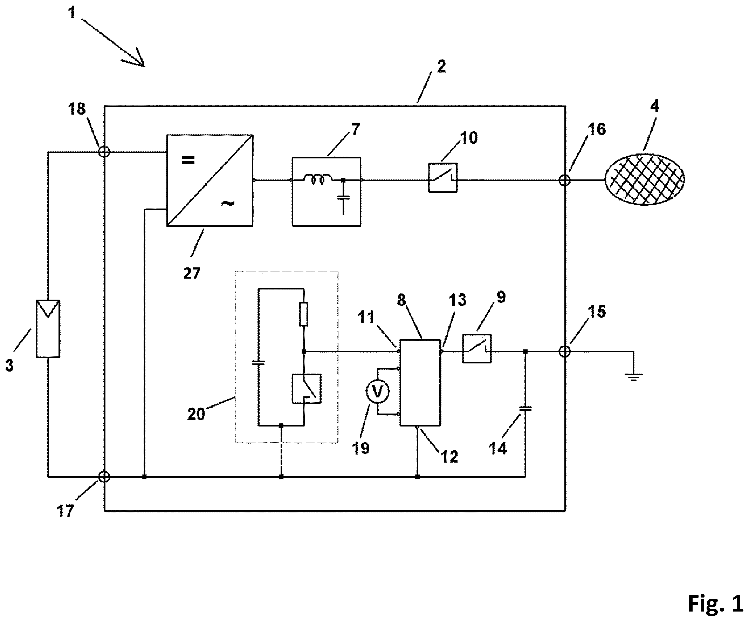

Fig. 1 zeigt einen Wechselrichter 2, der zur Ausführung des erfindungsgemäßen Verfahrens eingerichtet ist. Ein Solargenerator 3 ist an einen ersten Pol 17 und einen zweiten Pol 18 des Wechselrichters 2 angeschlossen. Ein DC/AC-Wandler 21 ist eingangsseitig mit den beiden Polen 17, 18 verbunden und dient zur Wandlung der DC-Leistung des Solargenerators 3 in eine AC-Leistung, die ausgangsseitig über einen Netzfilter 7 und ein Netzrelais 10 an einem Netzanschluss 16 zur Einspeisung in ein angeschlossenes Netz 4 bereitgestellt wird. Zur einfehlersicheren Bestimmung eines Isolationswiderstands des Solargenerators 3 ist eine variable Spannungsquelle 20 vorgesehen, die an einen ersten Anschluss eines Widerstandsnetzwerks 8 angeschlossen ist, wobei das Widerstandsnetzwerk 8 weiterhin einen zweiten Anschluss 12, der mit dem ersten Pol 17 verbunden ist, und einen dritten Anschluss 13 aufweist, der über ein Isolationsrelais 9 mit einem Erdanschluss 15 verbunden ist. Eine in dem Widerstandsnetzwerk 8 abfallende Prüfspannung wird mittels einer Messeinrichtung 19 bestimmt. Weiterhin verbindet ein Kondensator 14 den Erdanschluss 15 mit dem ersten Pol 17. Der Kondensator 14 wird vielfach auch als Y-Kondensator bezeichnet und dient unter anderem zur Verbesserung des EMV-Verhaltens des Wechselrichters 2.

Die variable Spannungsquelle 20 kann durch eine Gleichspannungsquelle, beispielsweise einen Kondensator, gebildet sein, der über den Mittelpunkt einer Serienschaltung eines Widerstand und eines Schalter eine Spannung an dem ersten Anschluss bereitstellt, die über den Schaltzustand des Schalters variabel eingestellt werden kann. Der Kondensator kann beispielsweise durch ein Bordnetz des Wechselrichters 2 auf eine vorgegebene Spannung geladen werden. Die Energie hierzu kann sowohl dem Solargenerator 3 als auch dem Netz 4 entnommen werden. Die variable Spannungsquelle 20 hat einen festen Potenzialbezug zu einem Potenzial des Solargenerators und ist zum Beispiel mit einem Pol direkt mit dem ersten Pol 17 verbunden, wie in der Fig. 1 über eine gestrichelte Linie angedeutet.

Durch eine geeignete Ansteuerung des Isolationsrelais 9 und der variablen Spannungsquelle 20 können die unterschiedlichen Spannungsverläufe am ersten Anschluss 11 bei entsprechenden Schaltzustand des Isolationsrelais 9 gemäß den Schritten des erfindungsgemäßen Verfahrens erzeugt, sowie die Prüfspannungen beziehungsweise deren Amplituden in den einzelnen Schritten ermittelt werden. Die Schritte des Verfahrens werden bevorzugt vor dem Zuschalten des Wechselrichters 2 an das Netz 4 durchgeführt und das Netzrelais 10 nur dann geschlossen, wenn die Bestimmung des Isolationswiderstands sowohl ein funktionstüchtiges Isolationsrelais 9 als auch einen hinreichend hohen Isolationswiderstand des angeschlossenen Solargenerators 3 ergeben hat.

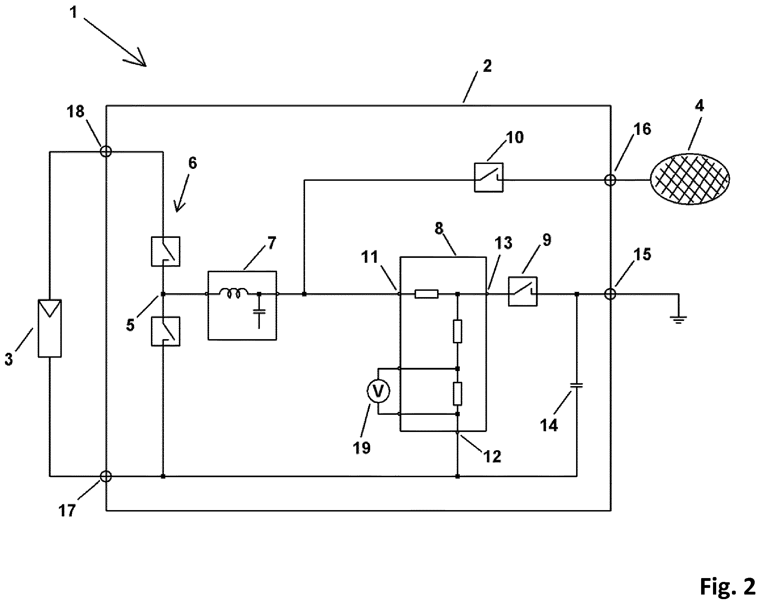

Fig. 2 zeigt eine vorteilhafte Ausführung des Wechselrichters 2, bei dem die variable Spannungsquelle durch eine Wechselrichterbrücke 6 gebildet wird, die zwischen dem ersten Pol 17 und dem zweiten Pol 18 angeordnet ist, und deren Mittelpunkt 5 als Brückenausgang über den Netzfilter 7 mit dem ersten Anschluss 11 des Widerstandsnetzwerks 8 verbunden ist. Das Anlegen der Gleichspannungen und Erzeugen der Wechselspannungen am ersten Anschluss 11 im Rahmen des erfindungsgemäßen Verfahrens erfolgt durch geeignete Ansteuerung der Schalter der Wechselrichterbrücke 6. Insbesondere kann ein erster Gleichspannungswert durch dauerhaftes Schließen des einen Halbbrückenschalters am ersten Anschluss 11 angelegt werden, wodurch der erste Pol (17) mit dem ersten Anschluss 11 verbunden wird. Entsprechend kann ein zweiter Gleichspannungswert durch dauerhaftes Schließen des anderen Halbbrückenschalters am ersten Anschluss 11 angelegt werden, wodurch der zweite Pol 18 mit dem ersten Anschluss 11 verbunden wird. Die Wechselspannung kann am ersten Anschluss 11 durch alternierendes getaktetes Ansteuern beider Halbbrückenschalter in bekannter Weise erzeugt werden.

Im vorliegenden Fall besteht das Widerstandsnetzwerk 8 aus einem resistiven Spannungsteiler, der drei zwischen dem ersten Anschluss 11 und dem zweiten Anschluss 12 in Reihe geschaltete Widerstände umfasst. Der Mittelpunkt zwischen dem mit dem ersten Anschluss 11 verbundenen Widerstand und dem mittleren Widerstand ist mit dem dritten Anschluss 13 verbunden. Eine Messeinrichtung 19 bestimmt eine Prüfspannung, die über dem mit dem zweiten Anschluss 12 verbundenen Widerstand des Spannungsteilers abfällt.

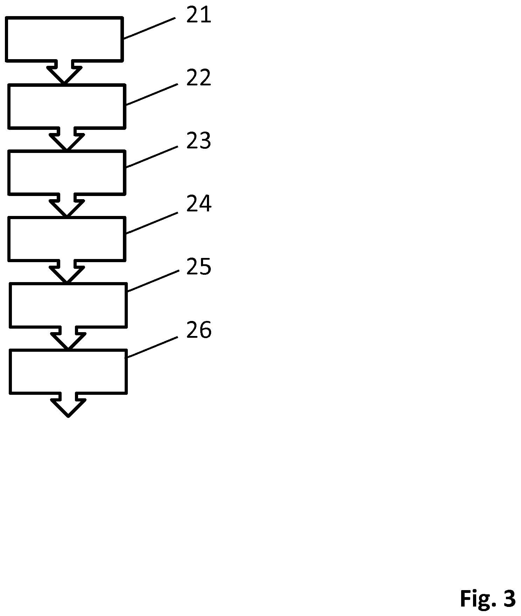

Fig. 3 zeigt einen Ablauf des erfindungsgemäßen Verfahrens, das zum Beispiel mit dem in Fig. 1 oder in Fig. 2 beschriebenen Wechselrichter ausgeführt wird. In einem ersten Schritt 21 wird durch eine variable Gleichspannungsquelle ein erster Gleichspannungswert an einem ersten Anschluss eines Widerstandsnetzwerks bei geschlossenem Isolationsrelais angelegt. Beispielsweise wird ein erster Pol eines Solargenerators mit einem ersten Anschluss eines Widerstandsnetzwerks verbunden. Diese Verbindung kann durch das Schließen eines ersten Schalters einer Halbbrücke des Wechselrichters erfolgen, der mit dem ersten Pol des Solargenerators verbunden ist.

In einem zweiten Schritt 22 wird durch die variable Gleichspannungsquelle ein zweiter Gleichspannungswert an dem ersten Anschluss des Widerstandsnetzwerks angelegt, wobei das Isolationsrelais ebenfalls geschlossen ist. Beispielsweise wird der zweite Pol des Solargenerators mit dem ersten Anschluss verbunden. Diese Verbindung kann durch das Schließen eines zweiten Schalters der Halbbrücke des Wechselrichters erfolgen, der mit dem zweiten Pol des Solargenerators verbunden ist.

In einem dritten Schritt 23 wird durch die variable Gleichspannungsquelle, insbesondere durch eine zwischen dem ersten und dem zweiten Pol angeordnete Wechselrichterbrücke, eine Wechselspannung am ersten Anschluss erzeugt, während das Isolationsrelais geschlossen ist. In einem vierten Schritt 24 wird das Isolationsrelais geöffnet, während weiterhin die Wechselspannung durch die variable Gleichspannungsquelle am ersten Anschluss erzeugt wird.

Die Schritte 21 bis 24 können bei dem Verfahren in beliebiger Reihenfolge durchgeführt werden. Bei jedem Schritt wird jeweils eine Prüfspannung ermittelt, die über einem Widerstand des Widerstandsnetzwerks abfällt. Eine Funktionsprüfung des Isolationsrelais wird in einem fünften Schritt 25 durch Vergleich der Amplitude der Prüfspannung zwischen dem dritten Schritt 23 und dem vierten Schritt 24 durchgeführt. Weiterhin wird in einem sechsten Schritt 26 der Isolationswiderstand aus den im Rahmen der Schritte 21 bis 24 ermittelten Prüfspannungen bestimmt. Bevorzugt wird der Isolationswiderstand aus einer Differenz zwischen der im ersten Schritt 21 und der im zweiten Schritt 22 ermittelten Prüfspannungen bestimmt. Es ist aber auch denkbar, dass die Amplitude der Prüfspannung im dritten Schritt 23 und/oder vierten Schritt 24 bei der Bestimmung des Isolationswiderstandes berücksichtigt werden. Ebenfalls denkbar ist es, den sechsten Schritt 26 vor dem fünften Schritt 25 oder nur unter der Bedingung, dass der fünfte Schritt 25 zu dem Ergebnis geführt hat, dass das Isolationsrelais funktionstüchtig ist, auszuführen.

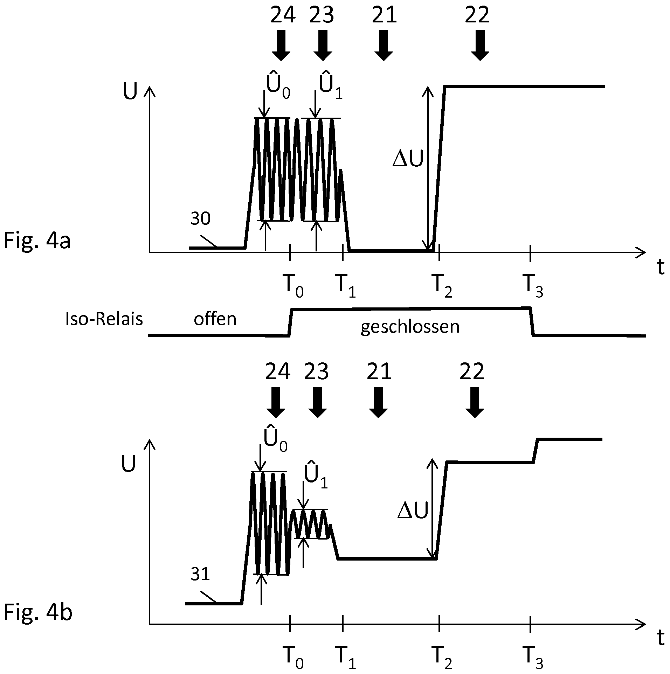

Ein möglicher Verlauf 30 der Prüfspannung während der Ausführung des erfindungsgemäßen Verfahrens bei fehlerhaftem Isolationsrelais ist in Fig. 4a gezeigt, während der Verlauf 31 der Prüfspannung bei intaktem Isolationsrelais in der Fig. 4b gezeigt ist.

In den gezeigten Verläufen wird zunächst bis zu einem Zeitpunkt T₀ der vierte Schritt 24 ausgeführt, wodurch sich eine Wechselspannung mit einer Amplitude Û₀ als Prüfspannung ergibt. Anschließend wird bis zu einem Zeitpunkt T₁ der dritte Schritt 23 ausgeführt, indem das Isolationsrelais während der Erzeugung der Wechselspannung über die Wechselrichter-Halbbrücke geschlossen wird. Während des dritten Schritts 23 ergibt sich als Prüfspannung eine Wechselspannung mit einer Amplitude Û₁. In dem in Fig. 3a zugrunde gelegten Szenario ist das Isolationsrelais defekt, so dass es, zum Beispiel aufgrund korrodierter Relaiskontakte, nicht schließt oder, zum Beispiel aufgrund verschweißter Relaiskontakte, während beider Schritte 23, 24 geschlossen ist. Hierdurch ergibt sich, dass die Amplitude Û₀ sich nicht oder nicht wesentlich von der Amplitude Û₁ unterscheidet.

Anschließend wird bis zu einem Zeitpunkt T₂ der erste Schritt 21 ausgeführt und dann bis zu einem Zeitpunkt T₃ der zweite Schritt 22. Zum Zeitpunkt T₃ wird das Isolationsrelais wieder geöffnet. Aus der sich ergebenden Differenz ΔU zwischen den im ersten Schritt 21 und im zweiten Schritt 22 ermittelten Prüfspannungen kann ein Wert für den Isolationswiderstand ermittelt werden. Bei defektem Isolationsrelais ist der so bestimmte Wert allerdings nicht verlässlich, da beispielsweise aus der Differenz der Prüfspannung unabhängig von dem real vorliegenden Isolationswiderstand des Solargenerators ein für den Betrieb zulässig hoher Isolationswiderstandswert bestimmt wird, wenn das Isolationsrelais nicht in der Lage ist zu schließen. In diesem Fall kann es zu einem unzulässigen Betrieb der Photovoltaikanlage kommen, wenn der Ausfall des Isolationsrelais nicht erkannt wird.

Bei intaktem Isolationsrelais ergibt sich entsprechend des Verlaufs 31 der Prüfspannung nach Fig. 3b ebenfalls während des vierten Schrittes 24 eine Wechselspannung mit Amplitude Û₀ als Prüfspannung und während des dritten Schritts 23 eine Wechselspannung mit Amplitude Û₁. Da durch das Schließen des Isolationsrelais der angelegten Wechselspannung unabhängig von einem etwaigen Isolationswiderstand des Solargenerators ein zusätzlicher Strompfad zumindest über den Kondensator zwischen dem Erdanschluss und dem ersten Pol des Solargenerators geboten wird, ist die Amplitude Û₁ während des dritten Schritts 23 geringer als die Amplitude Û₀ während des vierten Schritts 24. Diese Differenz in der Amplitude wird dazu genutzt, ein funktionstüchtiges Isolationsrelais zu diagnostizieren. Beispielsweise kann ein Schwellwert vorgegeben sein, der als Differenz oder als Verhältnis zwischen den Amplituden den Fall eines funktionstüchtigen Isolationsrelais von dem Fall eines nicht funktionstüchtigen Isolationsrelais unterscheidet.

Aufgrund des Kondensators zwischen dem Erdanschluss und dem ersten Pol des Solargenerators ergeben sich auch Umladevorgänge insbesondere während des ersten Schritts 21 beziehungsweise des zweiten Schritts 22. Daher ist es vorteilhaft, die Dauer des ersten Schritts 21 beziehungsweise des zweiten Schritts 22 so zu gestalten, dass genug Zeit verbleibt, um den jeweiligen Umladevorgang abwarten zu können, bevor die Prüfspannung zu Bestimmung des Isolationswiderstandsmessung gemessen wird. Die Dauer des Umladevorgangs kann durch Wahl des Kapazitätswerts des Kondensator und der Widerstandswerte im Widerstandsnetzwerk geeignet gewählt werden. Natürlich ist es auch möglich, den Verlauf der Spannung während des Umladevorgangs zu erfassen und bei der Bestimmung der Prüfspannung zu berücksichtigen. Durch eine Auswertung des Spannungsverlaufs während des Umladevorgangs, der typischerweise einen exponentiellen Verlauf mit einer Abklingzeit aufweist, wird es insbesondere möglich, bei bekanntem Kapazitätswert des Kondensators eine durch eine Ableitkapazität des Solargenerators verursachte zusätzliche Kapazitätskomponente quantitativ zu erfassen und später beim Betrieb der Photovoltaikanlage zu berücksichtigen. Diese Erfassung kann auch über eine Auswertung der Amplituden der Prüfspannung während der Schritte 23 und 24 bei offenem beziehungsweise geschlossenem Isolationsrelais erfolgen.

### Bezugszeichenliste

- 1: Photovoltaikanlage
- 2: Wechselrichter
- 3: Solargenerator
- 4: Netz
- 5: Mittelpunkt
- 6: Wechselrichterbrücke
- 7: Netzfilter
- 8: Widerstandsnetzwerk
- 9: Isolationsrelais
- 10: Netzrelais
- 11: Anschluss
- 12: Anschluss
- 13: Anschluss
- 14: Kondensator
- 15: Erdanschluss
- 16: Netzanschluss
- 17: Pol
- 18: Pol
- 19: Messeinrichtung
- 20: variable Spannungsquelle
- 21-26: Schritt
- 27: DC/AC-Wandler
- 30, 31: Verlauf

## Patentansprüche

1. Verfahren zur einfehlersicheren Bestimmung eines Isolationswiderstands einer Photovoltaikanlage (1) umfassend einen Wechselrichter (2) und einen daran angeschlossenen Solargenerator (3), wobei der Isolationswiderstand in Abhängigkeit einer in einem Widerstandsnetzwerk (8) abfallenden Prüfspannung bestimmt wird, wobei das Widerstandsnetzwerk (8) über einen ersten Anschluss (11) mit einer variablen Spannungsquelle (20), über einen zweiten Anschluss (12) mit einem ersten Pol (17) des Solargenerators (3) und mit einem dritten Anschluss (13) über ein Isolationsrelais (9) mit einem Erdanschluss (15) des Wechselrichters (2) verbunden ist, wobei ein Kondensator (14) zwischen dem Erdanschluss (15) und dem ersten Pol (17) des Solargenerators (3) angeordnet ist, **dadurch gekennzeichnet, dass** das Verfahren die Schritte in beliebiger Reihenfolge umfasst:
- Anlegen eines ersten Gleichspannungswerts durch die variable Spannungsquelle (20) an den ersten Anschluss (11) bei geschlossenem Isolationsrelais (9) (Schritt 21)
- Anlegen eines zweiten Gleichspannungswerts durch die variable Spannungsquelle (20) an den ersten Anschluss (11) bei geschlossenem Isolationsrelais (9) (Schritt 22)
- Erzeugen einer Wechselspannung am ersten Anschluss (11) mithilfe der variablen Spannungsquelle (20) bei geschlossenem Isolationsrelais (9) (Schritt 23), sowie
- Erzeugen der Wechselspannung am ersten Anschluss (11) mithilfe der variablen Spannungsquelle (20) bei geöffnetem Isolationsrelais (9) (Schritt 24),
wobei eine Funktionsprüfung des Isolationsrelais (9) durch Vergleich der Amplitude der Prüfspannung zwischen den Schritten 23 und 24 durchgeführt wird.

2. Verfahren nach Anspruch 1, wobei der Isolationswiderstand in Abhängigkeit der Differenz der Prüfspannung zwischen den Schritten 21 und 22 bestimmt wird.

3. Verfahren nach einem der vorangehenden Ansprüche, durchgeführt, während der Wechselrichter (2) von einem Netz (4) getrennt ist.

4. Verfahren nach einem der vorangehenden Ansprüche, wobei die variable Spannungsquelle durch eine zwischen dem ersten Pol (17) und einem zweiten Pol (18) des Solargenerators (3) angeordnete Wechselrichterbrücke (6) des Wechselrichters (2) gebildet wird, deren Mittelpunkt (5), bevorzugt über einen Netzfilter (7), mit dem ersten Anschluss (11) verbunden ist.

5. Verfahren nach Anspruch 4, wobei der erste Gleichspannungswert durch Verbinden mit dem ersten Pol (17) und der zweite Gleichspannungswert durch Verbinden mit dem zweiten Pol (18) an dem ersten Anschluss (11) des Widerstandsnetzwerks (8) angelegt werden.

6. Verfahren nach einem der vorangehenden Ansprüche, wobei die Wechselspannung am ersten Anschluss (11) mit Netzfrequenz erzeugt wird.

7. Verfahren nach einem der vorangehenden Ansprüche, wobei das Verfahren in der Reihenfolge Schritt 24, dann Schritt 23, dann Schritt 21, dann Schritt 22 durchgeführt wird.

8. Verfahren nach einem der vorangehenden Ansprüche, wobei das Verfahren erneut durchgeführt wird, wenn die Funktionsprüfung des Isolationsrelais (9) oder die Bestimmung des Isolationswiderstands zu unzulässigen Ergebnissen geführt hat.

9. Verfahren nach einem der vorangehenden Ansprüche, wobei ein Fehlersignal im Falle einer negativen Funktionsprüfung und/oder im Falle eine unzulässig niedrig bestimmten Isolationswiderstands erzeugt wird.

10. Verfahren nach einem der vorangehenden Ansprüche, wobei die Prüfspannung als eine über einen mit dem ersten Pol (17) des Solargenerators (3) verbundenen Widerstand abfallende Spannung bestimmt wird.

11. Verfahren nach einem der vorangehenden Ansprüche, wobei der erste Anschluss (11) mit dem dritten Anschluss (13) über einen Begrenzungswiderstand verbunden ist.

12. Wechselrichter (2), umfassend ein Widerstandsnetzwerk (8) zur Bestimmung eines Isolationswiderstandes, wobei das Widerstandsnetzwerk (8) über einen ersten Anschluss (11) mit einer variablen Spannungsquelle (20) des Wechselrichters (2), über einen zweiten Anschluss (12) mit einem ersten Pol (17) des Wechselrichters (2) zum Anschluss eines Solargenerators (3) und mit einem dritten Anschluss (13) über ein Isolationsrelais (9) des Wechselrichters (2) mit einem Erdanschluss (15) des Wechselrichters (2) verbunden ist,
**dadurch gekennzeichnet, dass** ein Kondensator (14) zwischen dem Erdanschluss (15) und dem ersten Pol (17) angeordnet ist,
wobei der Wechselrichter (2) eingerichtet ist zur Durchführung des Verfahrens nach einem der vorangehenden Ansprüche.

## Claims

1. A method for a single-fault-tolerant determination of an isolation resistance of a photovoltaic system (1) comprising an inverter (2) and a solar generator (3) connected thereto, wherein the isolation resistance is determined as a function of a test voltage drop in a resistor network (8), wherein the resistor network (8) is connected to a variable voltage source (20) by way of a first terminal (11), to a first pole (17) of the solar generator (3) by way of a second terminal (12) and to a ground terminal (15) of the inverter (2) via an isolation relay (9) by way of a third terminal (13), wherein a capacitor (14) is disposed between the ground terminal (15) and the first pole (17) of the solar generator (3), **characterized in that** the method comprises the following steps in arbitrary order:
- applying by way of the variable voltage source (20) a first DC voltage value to the first terminal (11) when the isolation relay (9) is closed (step 21),
- applying by way of the variable voltage source (20) a second DC voltage value to the first terminal (11) when the isolation relay (9) is closed (step 22),
- generating an AC voltage at the first terminal (11) with the aid of the variable voltage source (20) when the isolation relay (9) is closed (step 23), and
- generating the AC voltage at the first terminal (11) with the aid of the variable voltage source (20) when the isolation relay (9) is open (step 24),
wherein the function of the isolation relay (9) is tested by comparing the amplitude of the test voltage between steps 23 and 24.

2. The method as claimed in claim 1, wherein the isolation resistance is determined as a function of the difference in the test voltage between steps 21 and 22.

3. The method as claimed in any one of the preceding claims, carried out while the inverter (2) is separated from a grid (4).

4. The method as claimed in any one of the preceding claims, wherein the variable voltage source is formed by an inverter bridge (6) of the inverter (2), said inverter bridge being disposed between the first pole (17) and a second pole (18) of the solar generator (3) and the midpoint (5) of said inverter bridge (6) being connected to the first terminal (11), preferably via a grid filter (7).

5. The method as claimed in claim 4, wherein the first DC voltage value is applied to the first terminal (11) of the resistor network (8) by a connection with the first pole (17) and the second DC voltage value is applied to said first terminal (11) of the resistor network (8) by a connection with the second pole (18).

6. The method as claimed in any one of the preceding claims, wherein the AC voltage is generated with grid frequency at the first terminal (11).

7. The method as claimed in any one of the preceding claims, wherein the method is carried out in the following sequence: step 24, followed by step 23, followed by step 21, followed by step 22.

8. The method as claimed in any one of the preceding claims, wherein the method is carried out again if the test of the function of the isolation relay (9) or the determination of the isolation resistance has led to inadmissible results.

9. The method as claimed in any one of the preceding claims, wherein a fault signal is generated in the case of a negative function test or in the case of an isolation resistance that has been determined as inadmissibly below.

10. The method as claimed in any one of the preceding claims, wherein the test voltage is determined as a voltage drop across a resistor connected to the first pole (17) of the solar generator (3).

11. The method as claimed in any one of the preceding claims, wherein the first terminal (11) is connected to the third terminal (13) via a limiting resistor.

12. An inverter (2) comprising a resistor network (8) for determining an insulation resistance, wherein the resistor network (8) is connected via a first terminal (11) to a variable voltage source (20) of the inverter (2), via a second terminal (12) to a first pole (17) of the inverter (2) for connection of a solar generator (3) and to a third terminal (13) via an insulation relay (9) of the inverter (2) to a ground terminal (15) of the inverter (2), **characterized in that** a capacitor (14) is arranged between the ground terminal (15) and the first pole (17), wherein the inverter (2) is adapted to perform the method according to one of the preceding claims.

## Revendications

1. Procédé de détermination de sécurité d'une résistance d'isolement d'une installation photovoltaïque (1) comprenant un onduleur (2) et un générateur photovoltaïque (3) raccordé à celui-ci, la résistance d'isolement étant déterminée en fonction d'une chute de tension d'essai dans un réseau de résistances (8), le réseau de résistances (8) étant relié par une première borne (11) à une source de tension variable (20), est relié par une deuxième borne (12) à un premier pôle (17) du générateur photovoltaïque (3) et à une troisième borne (13) par un relais d'isolement (9) à un point de mise à la terre (15) de l'onduleur (2), un condensateur (14) étant disposé entre le point de mise à la terre (15) et le premier pôle (17) du générateur photovoltaïque (3), **caractérisé en ce que** le procédé comprend les étapes dans un ordre quelconque :
- appliquer une première valeur de tension continue par la source de tension variable (20) à la première borne (11) avec le relais d'isolement (9) fermé (étape 21)
- appliquer une deuxième valeur de tension continue par la source de tension variable (20) à la première borne (11) avec le relais d'isolement (9) fermé (étape 22)
- générer une tension alternative à la première borne (11) en utilisant la source de tension variable (20) avec le relais d'isolement (9) fermé (étape 23), et
- générer la tension alternative à la première borne (11) à l'aide de la source de tension variable (20) lorsque le relais d'isolement (9) est ouvert (étape 24), un test fonctionnel du relais d'isolement (9) étant effectué en comparant l'amplitude de la tension d'essai entre les étapes 23 et 24.

2. Procédé selon la revendication 1, dans lequel la résistance d'isolement est déterminée en fonction de la différence de tension d'essai entre les étapes 21 et 22.

3. Procédure selon l'une des revendications précédentes, effectuée alors que l'onduleur (2) est déconnecté d'un réseau (4).

4. Procédé selon l'une des revendications précédentes, dans lequel la source de tension variable est formée par un pont onduleur (6) de l'onduleur (2) disposé entre le premier pôle (17) et un deuxième pôle (18) du générateur photovoltaïque (3), pont dont le point central (5) est relié à la première borne (11), de préférence par l'intermédiaire d'un filtre de réseau (7).

5. Procédé selon la revendication 4, dans lequel la première valeur de tension continue est appliquée par connexion au premier pôle (17) et la deuxième valeur de tension continue est appliquée par connexion au deuxième pôle (18) à la première borne (11) du réseau de résistances (8).

6. Procédé selon l'une des revendications précédentes, dans lequel la tension alternative est générée à la première borne (11) avec la fréquence du réseau.

7. Procédé selon l'une des revendications précédentes, le procédé étant exécuté dans l'ordre suivant : étape 24, puis étape 23, puis étape 21, puis étape 22.

8. Procédé selon l'une des revendications précédentes, le procédé étant répété si le test fonctionnel du relais d'isolement (9) ou la détermination de la résistance d'isolement a conduit à des résultats non admissibles.

9. Procédé selon l'une des revendications précédentes, dans lequel un signal d'erreur est généré en cas de test de fonctionnement négatif et/ou en cas de résistance d'isolement jugée trop faible.

10. Procédé selon l'une des revendications précédentes, dans lequel la tension d'essai est déterminée comme une tension chutant à travers une résistance connectée au premier pôle (17) du générateur photovoltaïque (3).

11. Procédé selon l'une des revendications précédentes, dans lequel la première borne (11) est reliée à la troisième borne (13) par une résistance de limitation.

12. Onduleur (2) comprenant un réseau de résistances (8) pour déterminer une résistance d'isolement, dans lequel le réseau de résistances (8) est connecté via une première borne (11) à une source de tension variable (20) de l'onduleur (2), est relié par une deuxième borne (12) à un premier pôle (17) de l'onduleur (2) pour le raccordement d'un générateur photovoltaïque (3) et à une troisième borne (13) par un relais d'isolement (9) de l'onduleur (2) à un point de mise à la terre (15) de l'onduleur (2), **caractérisé en ce qu'**un condensateur (14) est disposé entre le point de mise à la terre (15) et le premier pôle (17), l'onduleur (2) étant adapté pour réaliser le procédé selon l'une des revendications précédentes.
